# FASCICULE DE BREVET EUROPEEN

(11) **EP 3 211 367 B1**
(45) Date de publication et mention de la délivrance du brevet: **16.12.2020**
(21) Numéro de dépôt: 17166752.0
(22) Date de dépôt: 23.02.2010
(51) Int. Cl.: G01B 11/22, G01N 21/95, G01N 21/956, G02B 21/00, H01L 21/66

(54) **DISPOSITIF MICROSCOPE CONFOCAL CHROMATIQUE**
KONFOKALE CHROMATISCHE MIKROSKOPVORRICHTUNG
CHROMATIC CONFOCAL MICROSCOPE DEVICE

(30) Priorité: 25.02.2009 FR 0900862
(43) Date de publication de la demande: 30.08.2017
(62) Demande divisionnaire de: 10708249.7
(73) Titulaire: Fogale Nanotech, 30900 Nimes (FR)
(72) Inventeur: GASTALDO, Philippe, 38530 PONTCHARRA (FR)
(74) Mandataire: IPAZ

(56) Documents cités:
- WO-A-2008/007363
- US-A1- 2005 030 528
- US-A1- 2006 109 483
- US-A1- 2008 031 509
- US-A1- 2008 180 656
- US-B1- 6 580 502
- US-B1- 6 917 421

## Description

### Domaine technique

L'invention relève du domaine de l'inspection et du contrôle de plaquettes semiconductrices ou substrats en cours ou en fin de fabrication, ou lors de la réalisation de circuit intégrés.

### Etat de la technique antérieure

L'art antérieur dans le domaine est divulgué dans le document US 2008/031509 A1.

La tendance à l'accroissement des diamètres des plaquettes semi-conductrices fait que celles-ci doivent être manipulées avec un soin extrême et sont de plus en plus fragiles. Par ailleurs, la gravure de plus en plus fine des motifs d'une plaquette semi-conductrice rend chaque composant de la plaquette de plus en plus sensible aux défauts de fabrication.

L'augmentation du diamètre des substrats, la réduction de la taille des motifs et la recherche d'un rendement élevé lors de la fabrication de circuits intégrés poussent les fabricants et les utilisateurs de substrat à inspecter l'ensemble de la surface du substrat comprenant la face supérieure, la face inférieure et la tranche.

L'invention vise à améliorer la situation.

### Exposé de l'invention

L'invention est définie par la revendication 1.

J Un dispositif d'inspection de bord de plaquettes semi-conductrices comprend un microscope confocal chromatique pourvu d'une voie d'éclairage et d'une voie d'analyse. La voie d'éclairage comprend une source lumineuse polychromatique, une fente et un objectif à chromatisme axial choisi pour présenter une aberration chromatique, comportant au moins une lentille réalisée dans un matériau avec un nombre d'Abbe inférieur à 50. La voie d'analyse comprend ledit objectif, une fente de filtrage chromatique et un capteur d'intensité lumineuse dans cet ordre. La fente de la voie d'éclairage et la fente de la voie d'analyse sont disposées sensiblement à la même distance optique du bord de la plaquette à inspecter. En d'autres termes, lesdites fentes peuvent se situer à la même distance optique du bord de l'objectif. On parvient ainsi à filtrer spatialement les longueurs d'ondes non focalisées sur le bord de la plaquette semiconductrice en cours d'inspection.

Le procédé d'inspection de bord de plaquettes semi-conductrices comprend des étapes au cours desquelles on éclaire le bord par une source lumineuse polychromatique, le faisceau incident passant par une fente et par un objectif présentant une aberration, comportant au moins une lentille réalisée dans un matériau avec un nombre d'Abbe inférieur à 50, et on recueille le faisceau réfléchi après qu'il a passé par ledit objectif puis par une fente de filtrage chromatique configurée pour filtrer spatialement les longueurs d'ondes non focalisées sur le bord de la plaquette semi-conductrice. Le recueil est effectué par un capteur d'intensité lumineuse.

### Description des figures et modes de réalisation

L'invention sera mieux comprise à la lecture de la description détaillée de quelques modes de réalisation pris à titre d'exemple nullement limitatif et illustrés par les dessins annexés sur lesquels :
- la figure 1 est une vue schématique d'une plaquette semi-conductrice ;
- la figure 2 est une vue de détail de la figure 1 ;
- la figure 3 est une vue schématique d'un dispositif d'inspection de bord de plaquettes semi-conductrices ;
- la figure 4 est une variante de la figure 3 ;
- la figure 5 est une vue schématique d'un dispositif d'inspection selon un mode de réalisation ; et
- la figure 6 est une vue schématique d'une unité de traitement.

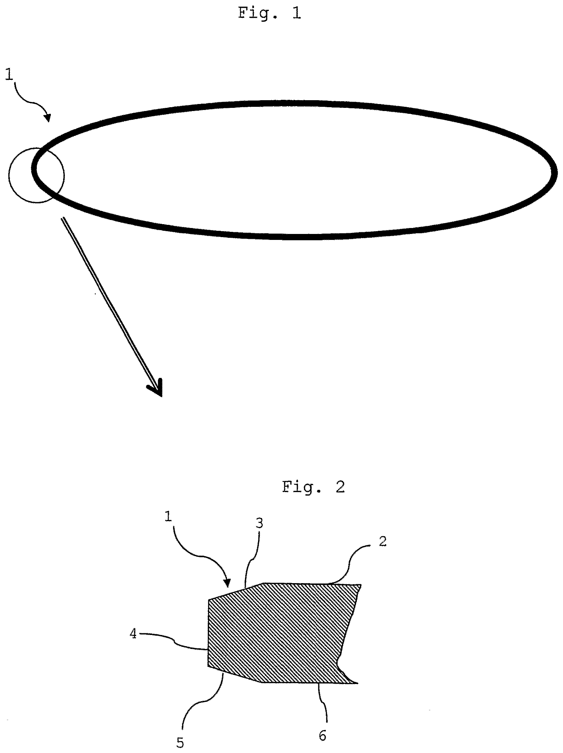

De façon générale, l'inspection de la tranche d'un substrat semi-conducteur 1 se fait en faisant tourner le substrat devant un système de vision, de type caméra matricielle ou linéaire. Par tranche de substrat, on entend le côté 4 sensiblement perpendiculaire aux surfaces supérieure et inférieure du substrat, le biseau supérieur 3 ou chanfrein, le biseau inférieur 5 ou chanfrein, la zone proche du bord supérieur 2 et la zone proche du bord inférieur 6, cf figures 1 et 2. Les surfaces opposées du substrat sont dites supérieures et inférieures par convention, même lorsque le substrat est en position verticale, par référence à une position horizontale du substrat lorsqu'il est supporté par un organe de manipulation telle qu'une fourche.

La limite des systèmes classiques réside principalement dans la profondeur de champ. En effet, la limite de diffraction optique fait qu'il est très difficile d'avoir un fort grossissement et une grande profondeur de champ avec un système optique classique. Ceci est particulièrement pénalisant lors du contrôle de la tranche d'un substrat. D'une part, la tranche étant courbée, la distance entre le système d'observation et la surface à contrôler n'est pas constante. Ceci limite le grandissement possible. D'autre part, le contrôle de la surface est fait lors d'une rotation de substrat. Afin d'assurer une distance entre l'objet et l'objectif la plus stable possible, le mouvement est fait à faible vitesse avec un système de manipulation extrêmement précis et stable. Ceci exige une cadence faible de mesure et des équipements de contrôle coûteux.

Pour des contrôles par prélèvement ou échantillonnage ou pour l'analyse de zones limitées à une faible partie de la surface du bord, on peut utiliser des systèmes d'inspection lents très performants avec un faible champ d'observation et un fort grossissement. Parmi ces systèmes lents, la microscopie confocale peut être choisie.

Toutefois, la vitesse d'acquisition des équipements de microscopie confocale ne permet pas de les utiliser en contrôle systématique de production de masse telle que la pratique l'industrie du semi-conducteur.

Or, la demanderesse a constaté que l'augmentation du diamètre des substrats augmente les contraintes mécaniques internes qu'ils subissent et augmente, par voie de conséquence, le risque de propagation de défauts, par exemple de microfissures situées sur le bord du substrat. Par ailleurs, l'augmentation du rendement, au sens du nombre de puces par substrat à diamètre égal, conduit à disposer des puces à proximité des bords. L'inspection des bords présente donc un intérêt de plus en plus grand.

Les documents WO 88/10406 et EP 0142464 montrent une technique d'analyse chromatique à travers une optique dispersive pour mesurer la ou les distances entre un capteur et un objet. Ces techniques sont très lentes.

Le document FR 2 805 342 concerne le contrôle de surface de substrats semiconducteurs, avec une fonction de mesure de reliefs de surface.

Le codage chromatique est utilisé dans le cadre de la mesure de distance pour régler le focus sur des équipements destinés à la photolithographie dans le domaine du semiconducteur. La mesure d'épaisseur ou de distance nécessite une analyse chromatique de la lumière réfléchie afin de convertir cette information en paramètre géométrique de l'objet mesuré. Cette conversion est lente.

L'invention fait appel à la microscopie confocale chromatique basée sur la microscopie confocale et l'exploitation de l'aberration chromatique du système optique utilisé. En général, un microscope confocal réajuste mécaniquement le point de focalisation de l'optique et en déduit la morphologie de la surface. Ce réajustement mécanique est lent et susceptible de provoquer des pannes. De plus, les mouvements étant généralement associés à des frottements, ils se révèlent souvent sources de particules, ce qui est à proscrire dans un environnement de production de composants micro électroniques.

Grâce à l'invention, on utilise une étroite plage de longueur d'ondes bien focalisée grâce à laquelle on obtient une image nette. L'analyse de la longueur d'ondes permet de déterminer, si cela est souhaité, la distance entre le capteur chromatique confocal et l'objet analysé. Avec un système optique à aberration chromatique forte, comportant au moins une lentille réalisée dans un matériau avec un nombre d'Abbe inférieur à 50, voire 35, des focalisations différentes se produisent pour des longueurs d'ondes différentes. Il en résulte un étalement spatial du point focal et une grande profondeur de champ. La profondeur de champ pourra atteindre plusieurs millimètres.

En conservant la longueur d'ondes ou une étroite plage de longueur d'ondes correspondant à la longueur d'ondes bien focalisée, on obtient un système autofocus optique. Ce système autofocus peut se passer de mouvement mécanique. Ceci est obtenu grâce aux fentes disposées à la même distance optique de la surface à inspecter ou encore de l'objectif, dans la mesure où l'objectif appartient à la fois à la voie d'éclairage et à la voie d'analyse. On peut ainsi réaliser une acquisition multipoint chacun ayant les propriétés avantageuses ci-dessus. La séparation des voies d'éclairage et d'analyse peut être effectuée par une lame semi-réfléchissante disposée entre la fente et l'objectif pour la voie d'éclairage et entre l'objectif et la fente de filtrage chromatique pour la voie d'analyse. La fente forme un organe de linéarisation.

La source lumineuse peut comprendre un ensemble de diodes électroluminescentes, par exemple sous la forme d'une barrette, et un organe de diffusion. L'organe de diffusion peut comprendre un verre dépoli.

Le dispositif peut comprendre une unité de traitement reliée à une sortie du capteur pour recevoir et analyser un signal d'intensité lumineuse. On peut prévoir une pluralité de capteurs d'intensité lumineuse pour inspecter une pluralité de facettes dudit bord, l'unité de traitement pouvant comprendre un assembleur de données de sortie des capteurs d'intensité lumineuse générant un fichier des résultats d'inspection pour ladite pluralité de capteurs. L'unité de traitement peut comprendre un discriminateur de défaut du bord générant un classement par type de défaut, par position, réflectivité, forme ou dimension.

Dans un mode de réalisation, le dispositif comprend un analyseur chromatique de la lumière rétrodiffusée ou réfléchie par un bord de la plaquette semi-conductrice avec une sortie reliée à l'unité de traitement. L'unité de traitement comprenant alors un extracteur générant des données de distance entre l'objectif et le bord de la plaquette semiconductrice.

L'objectif peut présenter un diamètre optique inférieur à 100mm, ce qui permettra par un encombrement plus faible d'intégrer le système dans un environnement restreint.

La surface à inspecter est disposée à une distance comprise dans la zone d'aberration chromatique, en d'autres termes à une distance comprise entre la longueur d'ondes de la lumière incidente présentant la focalisation la plus courte et la longueur d'ondes de la lumière incidente présentant la focalisation la plus longue. Le dispositif permet de faire un contrôle d'une tranche du bord de substrat et ce indépendamment d'un mécanisme de réglage de focalisation. Par une mesure continue de la tranche lors de la rotation du substrat, une image de la périphérie complète du substrat peut être réalisée.

Le dispositif d'inspection utilise l'information d'amplitude lumineuse fournie par le capteur pour offrir une image en niveau de gris avec un équipement économique et une acquisition très rapide permettant ainsi de proposer un système compatible avec une production de masse. Le dispositif présente une fonction d'autofocus automatique le rendant particulièrement simple, fiable et rapide, notamment par rapport aux systèmes d'imageries classiques. Le dispositif permet l'observation d'un grand champ avec des points dont la distance par rapport à l'objectif optique peut varier plus qu'avec un système d'imagerie classique présentant le même agrandissement.

A titre optionnel, la mesure de topographie par analyse chromatique de la lumière réfléchie peut être effectuée pour des applications plus précises et à plus faible cadence telle que l'analyse a posteriori de défauts détectés. La mesure de topographie peut aussi être utilisée pour quantifier la tombée de bord information particulièrement intéressante pour les substrats qui ont été reconditionnés et donc repolis.

La position de l'objectif par rapport à la surface à inspecter pourra se situer entre quelques millimètres et quelques centimètres de distance. Ceci permet de dégager le volume à proximité du substrat, volume généralement utilisé pour la manipulation du substrat par un ou plusieurs robots. Afin de collecter un maximum de lumière pour l'ouverture numérique donnée, on cherchera néanmoins à maintenir une faible distance entre la surface à contrôler et l'objectif.

La vitesse de rotation du substrat peut être comprise entre 0,1 et 10 tours par minute pour un substrat de 300 mm de diamètre, par exemple entre 1 et 10 tours par minute pour l'analyse d'intensité lumineuse. Cette vitesse de rotation sera à ajuster pour un substrat de diamètre différent afin de conserver une vitesse linéaire proche, par exemple dans une plage comprise entre 0,1 et 10 mètres par seconde, plus particulièrement entre 1 et 10 mètres par seconde pour l'analyse d'intensité lumineuse.

La résolution du capteur peut être comprise entre 128 et 10 000 pixels. La résolution peut être adaptée à la taille des défauts recherchés et à la cadence souhaitée. La source lumineuse peut comprendre une lampe à arc de type xénon, une lampe à incandescence, halogène ou une source à diodes électroluminescentes. Les diodes électroluminescentes sont avantageuses en termes de durée de vie, de faible consommation et de faible échauffement.

La lumière incidente générée par la source passe ensuite par la fente de la voie d'éclairage pour linéariser le faisceau. L'ensemble constitué par la source lumineuse et la fente de la voie incidente constitue une source lumineuse linéaire. Le faisceau incident passe ensuite par une lame semi-réfléchissante puis par l'objectif avant d'atteindre la surface à inspecter. Le faisceau réfléchi par la surface à inspecter passe par l'objectif puis par la lame semi-réfléchissante et en ressort selon un axe distinct de l'axe de la voie incidente.

Le faisceau réfléchi passe ensuite par la fente de filtrage chromatique assurant un filtrage spatial des longueurs d'ondes non focalisées sur la surface à inspecter d'où une amélioration de la netteté de l'image. En aval de la fente de filtrage chromatique, le faisceau réfléchi est essentiellement constitué par la longueur d'ondes ou l'étroite plage de longueur d'ondes focalisées et offre donc une image nette. Plus le chromatisme axial de l'objectif est élevé, plus une différence de longueur d'ondes se traduit par une différence élevée de distance de focalisation. Le faisceau réfléchi atteint ensuite le capteur d'intensité lumineuse. La sortie du capteur d'intensité lumineuse est reliée à l'unité de traitement.

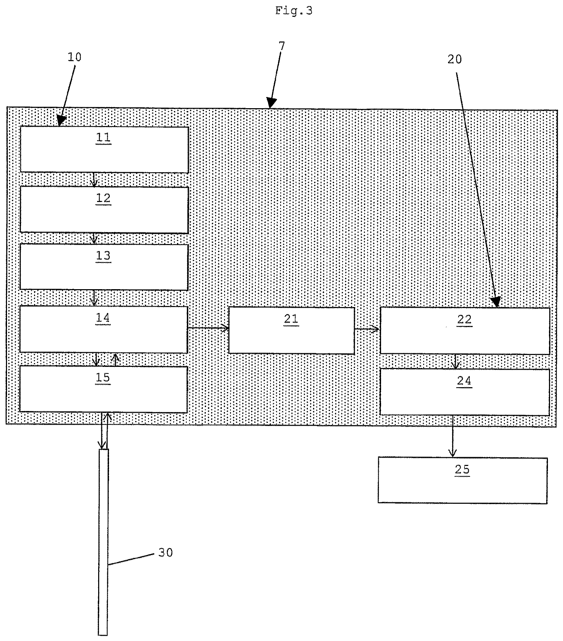

Comme on peut le voir sur la figure 3, le microscope confocal chromatique 7 comprend une voie d'éclairage 10 pour éclairer un objet 30 à inspecter, par exemple le bord d'un substrat semi-conducteur et une voie d'analyse 20 fournissant un signal de sortie pour une unité de traitement et d'analyse 25. La voie d'éclairage 10 et la voie d'analyse comprennent des parties communes notamment une lame semi-réfléchissante 14 et un objectif 15.

La voie d'éclairage 10 peut comprendre une source à large spectre 11 émettant un faisceau lumineux, une fente de filtrage spatial 12 recevant ledit faisceau lumineux, une optique de collimation 13 comprenant une ou plusieurs lentilles, ladite lame semi-réfléchissante 14 et ledit objectif 15. La lame semi-réfléchissante 14 reçoit le faisceau incident en provenance de l'optique de collimation 13. Le faisceau incident est dirigé 15 vers l'objectif 15 à partie de la sortie de la lame semi-réfléchissante 14. L'objectif 15 présente un fort chromatisme axial, par exemple dont une lentille au moins est réalisé dans un matériau caractérisé par une aberration chromatique de nombre d'Abbe inférieur à 50. A titre d'exemple, le nombre d'Abbe peut être égal à 35. Le faisceau incident atteint l'objet à inspecter 30 après la sortie de l'objectif 15. La source 11 peut comprendre une barrette de diodes 11a, un diffuseur 11b et une lentille de sortie 11c.

La voie d'analyse 20 comprend ledit objectif à fort chromatisme axial 15, la lame semi-réfléchissante 14 transmettant le faisceau réfléchi selon un axe différent de l'axe d'entrée du faisceau incident, vers une optique de focalisation qui rempliera la fonction inverse de l'optique de collimation 13, respectant le principe du retour inverse de la lumière. La voie d'analyse 20 comprend également une fente de filtrage spatial 22 disposée en aval de l'optique de focalisation 21. La fente 22 est disposée également à une distance de l'objet à inspecter 30 égale à la distance entre la fente de filtrage spatial 12 de la voie d'éclairage 10 et ledit objet à inspecter 30.

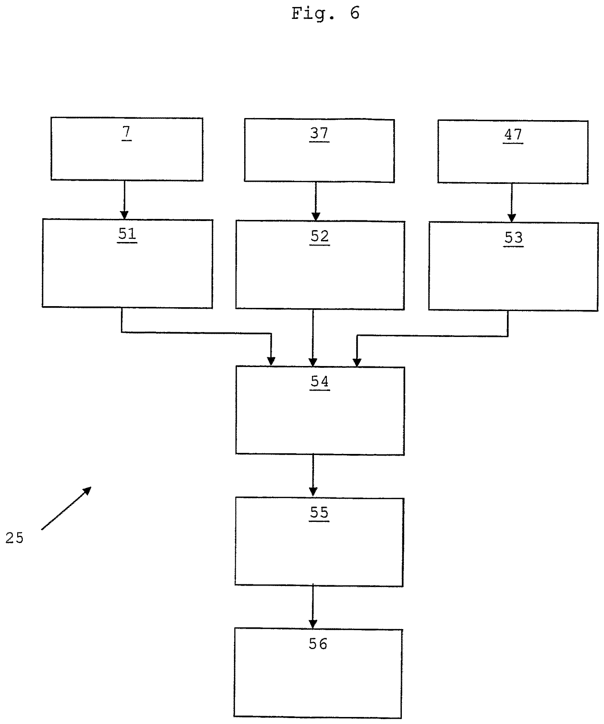

En aval de la fente de filtrage spatial 22, la voie d'analyse 20 comprend un capteur linéaire 24, disposé sur le trajet du faisceau réfléchi. Le capteur linéaire 24 peut se présenter sous la forme d'un ensemble d'éléments capteurs disposés en barrette. Les éléments capteurs peuvent être du type CCD ou encore CMOS. La sortie du microscope 7 en aval du capteur 24 est reliée à une unité de traitement et d'analyse 25 illustrée plus en détail sur la figure 6. Grâce à la présence des fentes de filtrage spatial 12 et 22 et au fort chromatisme axial de l'objectif 15, les longueurs d'ondes non focalisées sur la surface de l'objet à inspecter 30 sont filtrées en raison de leur décalage spatial rapport à la longueur d'onde focalisée, ce décalage étant d'autant plus grand que le chromatisme axial de l'objectif 15 est élevé. En sortie de la fente de filtrage spatial 22 de la voie d'analyse 20, le faisceau réfléchi filtré comprend une étroite plage de longueurs d'ondes sensiblement centrée sur la longueur d'onde focalisée, d'où une image d'une grande netteté et le fait que le faisceau réfléchi filtré est représentatif des défauts de la surface inspectée de l'objet 30.

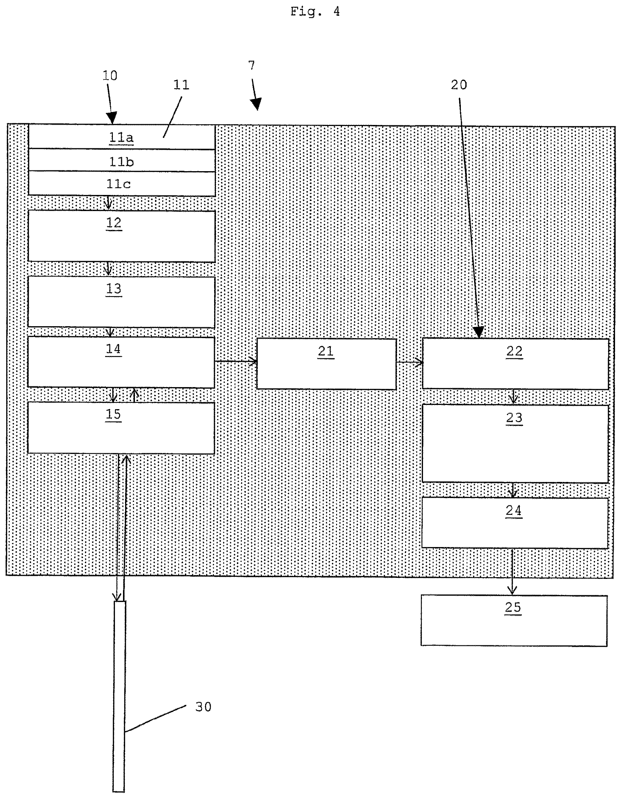

Dans ce mode de réalisation, le microscope 7 effectue une mesure de réflectivité de la surface à inspecter de l'objet 30. Des variations de la réflectivité sont représentatives de défauts de la surface inspectée. Il est possible d'en déduire des informations relativement précises sur la taille et le type de défauts. Dans le mode de réalisation illustré sur la figure 4, la voie d'analyse 20 du microscope 7 comprend, en outre, un élément dispersif 23 disposé entre la fente de filtrage spatial 22 et le capteur 24 sur le trajet du faisceau réfléchi filtré. L'élément dispersif 23 aura pour fonction de séparer spatialement les longueurs d'ondes. Le spectre ainsi obtenu sera projeté sur un capteur, et l'information de la longueur d'onde la plus intense sera alors disponible, et donnera une image de la distance de focalisation optimale. L'élément dispersif 23 peut être un réseau de diffraction. Le microscope 7 fournit alors en sortie un signal représentatif de la distance locale du microscope 7 par rapport à la surface inspectée de l'objet 30 dont est déduite la topographie de la surface inspectée. Une unité de traitement de l'information chromatique réalise une conversion de la longueur d'onde en distance entre le bord de plaquette à inspecter et l'objectif du capteur. Ce mode de réalisation fournit un signal relativement lourd à traiter. Il s'avère intéressant pour un contrôle sur échantillon ou sur des substrats semi-conducteurs présentant des défauts détectés par d'autres moyens, par exemple par un microscope 7 selon le mode de réalisation de la figure 3 susceptible d'être intégré dans une chaîne de fabrication de substrats semi-conducteurs.

On peut donc prévoir un microscope selon le mode de réalisation de la figure 3 disposé sur la chaîne de fabrication et inspectant un grand nombre, voire la totalité, des substrats semi-conducteurs fabriqués et un microscope selon le mode de réalisation de la figure 4 pour inspecter des substrats semi-conducteurs présentant des défauts précédemment détectés, cette inspection pouvant être 2 à 10 fois plus lente que la précédente. Le microscope selon le mode de réalisation de la figure 4 est alors disposé à part de la chaîne de fabrication afin de recevoir les substrats semi-conducteurs sélectionnés en raison de leurs défauts.

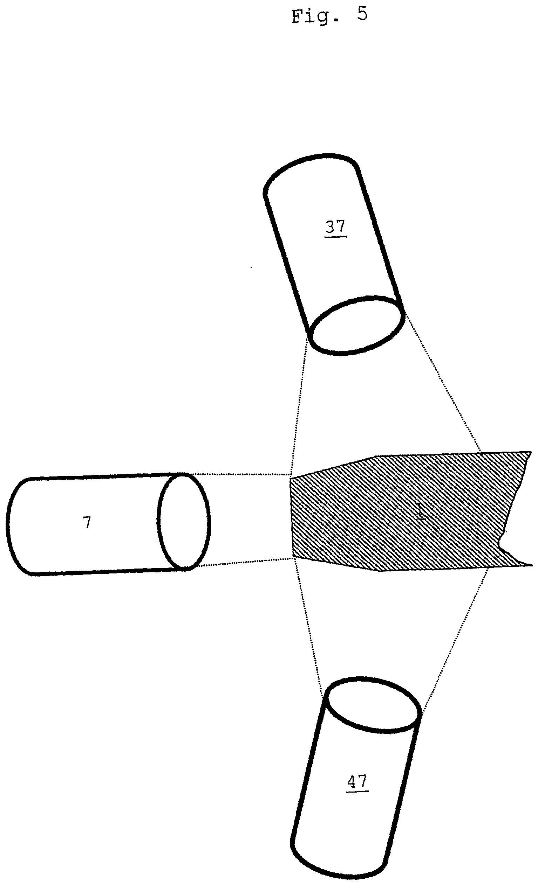

Dans le mode de réalisation illustré sur la figure 5, une pluralité de microscopes 7, 37 et 47 sont disposés pour inspecter le bord d'un substrat semi-conducteur (1). Les microscopes 7, 37 et 47 peuvent être conformes au mode de réalisation de la figure 3. Le microscope 7 est positionné en face du côté 4 du substrat 1. Le microscope 37 est disposé au-dessus du substrat 1 pour inspecter le biseau supérieur 3 et la zone proche du bord supérieur 2. Le microscope 47 est disposé sous le substrat 1 pour inspecter le biseau inférieur 5 et la zone proche du bord inférieur 6. Les sorties des microscopes 7, 37 et 47 peuvent être reliées à une unité de traitement et d'analyse commune, voire figure 6.

L'unité de traitement et d'analyse 25 comprend une pluralité de cartes d'acquisition, ici au nombre de trois. Chaque carte d'acquisition 51, 52, 53 est reliée à la sortie d'un microscope confocal chromatique 7, 37, 47. L'unité de traitement et d'analyse comprend également un organe de reconstruction d'images 54 configuré pour générer une image à partir des images fournies en sortie par les cartes d'acquisition 51, 52, 53. L'organe de reconstruction d'images procède à une comparaison de l'extrémité supérieure 15 de l'image du côté 4 avec l'extrémité inférieure de l'image du biseau supérieur 3 et une comparaison du bord inférieur de l'image du côté 4 avec le bord supérieur de l'image du biseau inférieur 5. L'organe de reconstruction d'images 54 effectue une détection d'un recouvrement éventuel à partir du résultat de la comparaison et un assemblage.

L'unité de traitement et d'analyse 25 comprend un ou plusieurs organes de traitement 20 d'images 55, par exemple sous forme logicielle, pour faciliter la détection des défauts. Les organes de traitement d'images 55 peuvent effectuer des opérations de dilatation, d'érosion, de contour, etc.. Par ailleurs, les organes de traitement d'images 55 peuvent comprendre une bibliothèque de défauts et un comparateur pour comparer les défauts suspectés à des défauts connus et répertoriés dans la bibliothèque. L'organe de traitement 25 d'images 55 est configuré pour générer en sortie un fichier de résultats, notamment sous la forme d'un fichier image.

Dans un autre mode de réalisation, on pourra avoir un traitement des images avant reconstruction, permettant ainsi d'avoir un traitement facilité par une taille d'image plus petite. Une combinaison des résultats permettra de produire un fichier résultat de synthèse.

## Revendications

1. Dispositif microscope confocal chromatique (7) pour produire une mesure de réflectivité de la surface d'un objet (30) à inspecter, **caractérisé en ce qu'**il comprend une voie d'éclairage (10) et une voie d'analyse (20), la voie d'éclairage (10) comprenant une source lumineuse polychromatique (11), une fente de filtrage spatial (12) et un objectif (15) à fort chromatisme axial comportant au moins une lentille réalisée dans un matériau avec un nombre d'Abbe inférieur à 50, la voie d'analyse (20) comprenant ledit objectif (15) à fort chromatisme axial, une fente de filtrage chromatique (22) et un capteur linéaire d'intensité lumineuse (24), dans cet ordre, permettant une acquisition multipoints, le capteur linéaire d'intensité lumineuse (24) produisant une information d'intensité lumineuse, la fente de filtrage spatial (12) et la fente de filtrage chromatique (22) étant disposées à la même distance optique de l'objectif (15) à fort chromatisme axial, et la fente de filtrage chromatique (22) assurant un filtrage spatial des longueurs d'onde non focalisées sur la surface de l'objet (30) de sorte que le faisceau atteignant le capteur linéaire d'intensité lumineuse (24) soit essentiellement constitué par la plage de longueur d'ondes focalisées sur ladite surface et produise une image nette.

2. Dispositif selon la revendication précédente, comprenant une lame semi réfléchissante (14) disposée entre la fente de filtrage spatial (12) et la fente de filtrage chromatique (22) d'une part, et l'objectif (15) à fort chromatisme axial d'autre part.

3. Dispositif selon l'une des revendications précédentes, dans lequel la fente (12) de la voie d'éclairage forme un organe de linéarisation, de sorte à constituer avec la source lumineuse (11) une source lumineuse linéaire.

4. Dispositif selon l'une des revendications précédentes, dans lequel la source lumineuse comprend l'une des sources suivantes : une lampe à arc, une lampe à incandescence, une lampe halogène, une source à diodes électrol uminescentes.

5. Dispositif selon l'une des revendications 1 à 3, dans lequel la source lumineuse (11) comprend un ensemble de diodes électroluminescentes (11a) ou une barrette de diodes électroluminescentes (11a).

6. Dispositif selon la revendication 5, dans lequel la source lumineuse (11) comprend un diffuseur (11b).

7. Dispositif selon l'une des revendications précédentes, dans lequel le capteur (24) comprend un ensemble d'éléments capteurs disposés en barrette.

8. Dispositif selon la revendication 7, dans lequel les éléments capteurs sont de type CCD ou CMOS.

9. Dispositif selon l'une des revendications précédentes, comprenant une unité de traitement (25) reliée à une sortie du capteur d'intensité lumineuse (24) pour recevoir et analyser l'information d'intensité lumineuse.

10. Dispositif selon l'une des revendications précédentes, dans lequel l'unité de traitement (25) utilise l'information d'intensité lumineuse pour produire une image en niveaux de gris.

## Patentansprüche

1. Chromatische konfokale Mikroskopvorrichtung (7) zur Erzeugung einer Reflektivitätsmessung der Oberfläche eines zu untersuchenden Objektes (30), **dadurch gekennzeichnet, dass** sie einen Beleuchtungsweg (10) und einen Analyseweg (20) umfasst, wobei der Beleuchtungsweg (10) eine polychromatische Lichtquelle (11), einen räumlichen Filterspalt (12) und ein Objektiv (15) mit hohem axialen Chromatismus, umfassend wenigstens eine Linse aus einem Material mit einer Abbeschen Zahl von weniger als 50, umfasst, wobei der Analyseweg (20) das Objektiv (15) mit hohem axialen Chromatismus, einen chromatischen Filterspalt (22) und einen linearen Lichtintensitätssensor (24), in dieser Reihenfolge, umfasst, der eine Mehrpunkterfassung ermöglicht, wobei der lineare Lichtintensitätssensor (24) eine Lichtintensitätsinformation erzeugt, wobei der räumliche Filterspalt (12) und der chromatische Filterspalt (22) im gleichen optischen Abstand von dem Objektiv (15) mit hohem axialen Chromatismus angeordnet sind, und wobei der chromatische Filterspalt (22) eine räumliche Filterung der nicht fokussierten Wellenlängen auf der Oberfläche des Objektes (30) sicherstellt, so dass der Strahl, der den linearen Lichtintensitätssensor (24) erreicht, im Wesentlichen aus dem Wellenlängenbereich von auf die Oberfläche fokussierten Wellen besteht und ein scharfes Bild erzeugt.

2. Vorrichtung nach dem vorhergehenden Anspruch, umfassend eine halbreflektierende Platte (14), die zwischen dem räumlichen Filterspalt (12) und dem chromatischen Filterspalt (22) einerseits und dem Objektiv (15) mit hohem axialen Chromatismus andererseits angeordnet ist.

3. Vorrichtung nach einem der vorhergehenden Ansprüche, bei der der Spalt (12) des Beleuchtungsweges ein Linearisierungsorgan bildet, um mit der Lichtquelle (11) eine lineare Lichtquelle zu bilden.

4. Vorrichtung nach einem der vorhergehenden Ansprüche, bei der die Lichtquelle eine der folgenden Quellen umfasst: eine Bogenlampe, eine Glühlampe, eine Halogenlampe, eine Leuchtdiodenquelle.

5. Vorrichtung nach einem der Ansprüche 1 bis 3, bei der die Lichtquelle (11) eine Anordnung von Leuchtdioden (11a) oder eine Leuchtdiodenleiste (11a) umfasst.

6. Vorrichtung nach Anspruch 5, bei der die Lichtquelle (11) einen Diffusor (11b) umfasst.

7. Vorrichtung nach einem der vorhergehenden Ansprüche, bei der der Sensor (24) eine Anordnung von leistenförmig angeordneten Sensorelementen umfasst.

8. Vorrichtung nach Anspruch 7, bei der die Sensorelemente vom CCD- oder CMOS-Typ sind.

9. Vorrichtung nach einem der vorhergehenden Ansprüche, umfassend eine Verarbeitungseinheit (25), die mit einem Ausgang des Lichtintensitätssensors (24) verbunden ist, um die Lichtintensitätsinformation zu empfangen und zu analysieren.

10. Vorrichtung nach einem der vorhergehenden Ansprüche, bei der die Verarbeitungseinheit (25) die Lichtintensitätsinformation verwendet, um ein Graustufenbild zu erzeugen.

## Claims

1. Confocal chromatic microscope device (7) for producing a reflectivity measure of the surface of an object (30) to be inspected, **characterized in that** it comprises a lighting path (10) and an analysis path (20), the lighting path (10) comprising a polychromatic light source (11), a spatial filtering slot (12), and an objective (15) with strong axial chromatism comprising at least a lens made of a material having an Abbe number of less than 50, the analysis path (20) comprising said objective (15) with strong axial chromatism, a chromatic filtering slot (22), and a linear light intensity sensor (24), in this order, allowing for a multipoint acquisition, the linear light intensity sensor (24) producing a light intensity information, the spatial filtering slot (12) and the chromatic filtering slot (22) being arranged at the same optical distance from the objective (15) with strong axial chromatism, and the chromatic filtering slot (22) ensuring a spatial filtering of the wavelengths not focalized on the surface of the object (30) so that the beam attaining the linear light sensor (24 substantially consists of the range of wavelengths focalized on said surface and produces a sharp image.

2. Device according to the preceding claim, comprising a semireflective plate (14) arranged between the spatial filtering slot (12) and the chromatic filtering slot (22) on one side, and the objective (15) with strong axial chromatism on the other side.

3. Device according to one of the preceding claims, wherein the slot (12) of the lighting path forms a linearization organ, so that it constitutes with the light source (11) a linear light source.

4. Device according to one of the preceding claims, wherein the light source comprises one of the following sources: an arc lamp, an incandescent lamp, a halogen lamp, an electroluminescent diode source.

5. Device according to one of claims 1 to 3, wherein the light source (11) comprises a set of electroluminescent diodes (11a) or a bar of electroluminescent diodes (11a).

6. Device according to claim 5, wherein the light source (11) comprises a diffuser (lib).

7. Device according to one of the preceding claims, wherein the sensor (24) comprises a set of sensor elements arranged as a bar.

8. Device according to claim 7, wherein the sensor elements are of the CCD or CMOS type.

9. Device according to one of the preceding claims, comprising a processing unit (25) connected to an output of the light intensity sensor (24) to receive and analyze the light intensity information.

10. Device according to one of the preceding claims, wherein the processing unit (25) uses the light intensity information to produce a grey level image.
